# EUROPEAN PATENT APPLICATION

(11) **EP 3 522 369 A1**
(43) Date of publication of application: **07.08.2019**
(21) Application number: 18181417.9
(22) Date of filing: 03.07.2018
(51) Int. Cl.: H02S 20/23

(54) **SPLICING MECHANISM FOR FIXING PHOTOVOLTAIC MODULE AND PHOTOVOLTAIC CURTAIN WALL**

(30) Priority: 31.01.2018 CN 201820167470 U
(71) Applicant: Beijing Apollo Ding Rong Solar Technology Co., Ltd., Beijing 100176 (CN)
(72) Inventor: Shi, Qingwen, Beijing, 100176 (CN); Wang, Hong, Beijing, 100176 (CN); Lin, Junrong, Beijing, 100176 (CN); Jiang, Wei, Beijing, 100176 (CN); Lv, Hejiang, Beijing, 100176 (CN); Qi, WeiBin, Beijing, 100176 (CN); Zhang, Xueliang, Beijing, 100176 (CN)
(74) Representative: Soria Parra, Manuel

(57) **Abstract**

The present disclosure provides a splicing mechanism for fixing a photovoltaic module and a photovoltaic curtain wall. The splicing mechanism includes a supporting bracket with a fixing groove and a sliding rail detachably mounted in the fixing groove. The sliding rail is provided with a sliding groove for mounting the photovoltaic module. A preset inclination angle is defined between the sliding groove and a bottom surface of the sliding rail. A first end of a first sliding groove coincides with a first end of the sliding rail; and a second end of the second sliding groove coincides with a second end of the sliding rail.

## Description

### TECHNICAL FIELD

The present disclosure relates to the field of photovoltaic technology, and in particular to a splicing mechanism for fixing a photovoltaic module and a photovoltaic curtain wall.

### BACKGROUND

In related art, photovoltaic modules are important components of a photovoltaic power station. Cells encapsulated in the photovoltaic modules generate a direct current voltage according to the photovoltaic effect, thereby generating electricity. The photovoltaic modules are usually mounted to a mounting bracket to form a photovoltaic array to generate electricity. One common mounting bracket includes a supporting bracket, two opposite rims, a photovoltaic module mounted between the two rims, and a compression device disposed between the rims and used to fix the two rims to the supporting bracket. However, the compression device is fixed to the supporting bracket through screw bolts, and such an installation manner has disadvantages such as heavy workload of fixing installation, poor alignment of components in an array and no effect in waterproofing.

### SUMMARY

One object of the present disclosure is to provide a splicing mechanism for fixing a photovoltaic module and a photovoltaic curtain wall, which can solve the above problems in the related art, enhance waterproof performance and achieve quick installation and fixation of the photovoltaic module.

The present disclosure provides a splicing mechanism for fixing a photovoltaic module, which includes: a supporting bracket with a fixing groove; and a sliding rail detachably mounted in the fixing groove. The sliding rail is provided with a first sliding groove that extends a first preset distance from a first end of sliding rail towards a second end of the sliding rail, and a second sliding groove that extends a second preset distance from the second end of the sliding rail towards the first end of sliding rail; the first sliding groove is disposed obliquely; a projection of a center at a first end of the first sliding groove to a plane where a first end of the second sliding groove is located, coincides with a center at the first end of the second sliding groove; a projection of a second end of the first sliding groove to the plane where the first end of the second sliding groove is located, is below the first end of the second sliding groove; the first end of the first sliding groove coincides with the first end of the sliding rail; and the first end of the second sliding groove coincides with the second end of the sliding rail.

In the above splicing mechanism, optionally, the first preset distance is greater than the second preset distance.

In the above splicing mechanism, optionally, a partition plate is disposed between the second sliding groove and the first sliding groove in a direction perpendicular to a bottom surface of the sliding rail.

In the above splicing mechanism, optionally, the second sliding groove is of a bell shape with a size gradually reducing in a direction from the first end of the second sliding groove towards the second end of the second sliding groove.

In the above splicing mechanism, optionally, the supporting bracket is provided with a waterproof groove.

In the above splicing mechanism, optionally, the supporting bracket includes a supporting portion, a vertical plate, and a cover plate; one end of the vertical plate is fixedly connected to a top surface of the supporting portion, and the other end of the vertical plate is fixedly connected to the cover plate; the fixing groove is defined between the cover plate, the vertical plate and the top surface of the supporting portion. The vertical plate is disposed at a symmetric center of the supporting portion, and the vertical plate divides a top portion above the supporting portion into two symmetrical fixing grooves.

In the above splicing mechanism, optionally, a drainage plate is disposed at each of two ends in a width direction of the supporting portion; the drainage plate protrudes out from the top surface of the supporting portion; and the drainage plates and the top surface of the supporting portion together define the waterproof groove.

In the above splicing mechanism, optionally, the supporting portion includes a top supporting plate, a bottom plate and two lateral supporting plates; one end of each of the two lateral supporting plates is fixedly connected to a respective one of two ends in a width direction of the top supporting plate; the other end of each of the two lateral supporting plates is fixedly connected to the bottom plate.

In the above splicing mechanism, optionally, a rib is provided on each of the top supporting plate and the bottom plate.

In the above splicing mechanism, optionally, an angle defined between the first sliding groove that is obliquely disposed and a bottom surface of the sliding rail is in a range of 0.47±0.03 degrees.

The present disclosure provides another splicing mechanism for fixing a photovoltaic module, which includes a sliding rail. The sliding rail is provided with a first sliding groove that extends from a first end of sliding rail towards a second end of the sliding rail, and a second sliding groove that extends from the second end of the sliding rail towards the first end of sliding rail; the first sliding groove is disposed obliquely relative to a bottom surface of the sliding rail; and a first end of the first sliding groove and a first end of the second sliding groove are at the same location on opposite sides of the sliding rail.

In the above splicing mechanism, optionally, the first sliding groove extends towards below the second sliding groove.

In the above splicing mechanism, optionally, the second sliding groove is disposed parallel to a bottom surface of the sliding rail.

In the above splicing mechanism, optionally, the first end of the second sliding groove has a taper-shaped opening.

Optionally, the above splicing mechanism further includes: a supporting bracket with a fixing groove, in which the sliding rail is detachably mounted.

In the above splicing mechanism, optionally, the supporting bracket includes a supporting portion, a vertical plate, and a cover plate; one end of the vertical plate is fixedly connected to a top surface of the supporting portion, and the other end of the vertical plate is fixedly connected to the cover plate; the fixing groove is defined between the cover plate, the vertical plate and the top surface of the supporting portion. The vertical plate is disposed at a symmetric center of the supporting portion, and the vertical plate divides a top portion above the supporting portion into two symmetrical fixing grooves.

In the above splicing mechanism, optionally, a drainage plate is disposed at each of two ends in a width direction of the supporting portion; the drainage plate protrudes out from the top surface of the supporting portion; and the drainage plates and the top surface of the supporting portion together define the waterproof groove.

In the above splicing mechanism, optionally, the supporting portion includes a top supporting plate, a bottom plate and two lateral supporting plates; one end of each of the two lateral supporting plates is fixedly connected to a respective one of two ends in a width direction of the top supporting plate; the other end of each of the two lateral supporting plates is fixedly connected to the bottom plate.

The present disclosure further provides a photovoltaic curtain wall which includes a plurality of photovoltaic modules and a plurality of above splicing mechanisms. Two opposite sides of each photovoltaic module are mounted into the first sliding grooves of two of the plurality of splicing mechanisms, and one ends of the two opposite sides protruding from the first sliding grooves are respectively inserted into the second sliding grooves of other two of the plurality of splicing mechanism adjacent to the two of the plurality of splicing mechanisms.

In the above photovoltaic curtain wall, optionally, multiple groups of splicing mechanisms for fixing photovoltaic module are disposed in parallel, with a photovoltaic module fixed between adjacent two of the groups of splicing mechanisms. As such, a photovoltaic curtain wall is formed by splicing together a plurality of photovoltaic modules photovoltaic module.

According to the splicing mechanism for fixing the photovoltaic module and the photovoltaic curtain wall provided in the present disclosure, the presence of the sliding rail on the supporting bracket achieves installation and fixation of the photovoltaic module; meanwhile, the sliding groove that is obliquely disposed in the sliding rail can solve problems of water accumulation on the photovoltaic module and achieve waterproof effects.

### BRIEF DESCRIPTION OF THE DRAWINGS

Fig. 1 is a schematic view of a splicing mechanism for fixing a photovoltaic module viewed from one perspective according to an embodiment of the present disclosure;
Fig. 2 is a schematic view of the splicing mechanism for fixing the photovoltaic module viewed from an another perspective according to an embodiment of the present disclosure;
Fig. 3 is a schematic view showing engagement between a sliding rail and a supporting bracket;
Fig. 4 is a schematic view showing two assembled splicing mechanisms according to an embodiment of the present disclosure;
Fig. 5 is a partial schematic view of the two assembled splicing mechanisms according to an embodiment of the present disclosure;
Fig. 6 is a partial enlarged view of the two assembled splicing mechanisms according to an embodiment of the present disclosure;
Fig. 7 is a schematic view of the sliding rail;
Fig. 8 is an enlarged view of a first end of the sliding rail;
Fig. 9 is an enlarged view of a second end of the sliding rail;
Fig. 10 is a front view of the supporting bracket; and
Fig. 11 is a cross-sectional view of a second sliding groove taken along a line A-A shown in Fig. 9.

### Reference numbers:

100- photovoltaic module
200- supporting bracket
210- cover plate
270- supporting portion
271- top supporting plate
272- lateral supporting plate
280- waterproof groove
220- vertical plate
230- bottom plate
240- rib
250- drainage plate
260- fixing groove
300- sliding rail
310- first sliding groove
320- second sliding groove
330- partition plate
α- angle
β- angle
X1- first end of first sliding groove
Y1- second end of first sliding groove
X2- first end of second sliding groove
Y2- second end of second sliding groove
Z1- first end of sliding rail
Z2- second end of sliding rail

### DETAILED DESCRIPTION

Detailed description of the exemplary embodiments will be made herein, with examples thereof to be shown in drawings. In the following descriptions, when the drawings are referred to, unless expressed otherwise, the same number in different drawings refers to the same or similar elements. The embodiments are intended to be exemplary only, and are not intended to limit the scope of the inventive concept in any way.

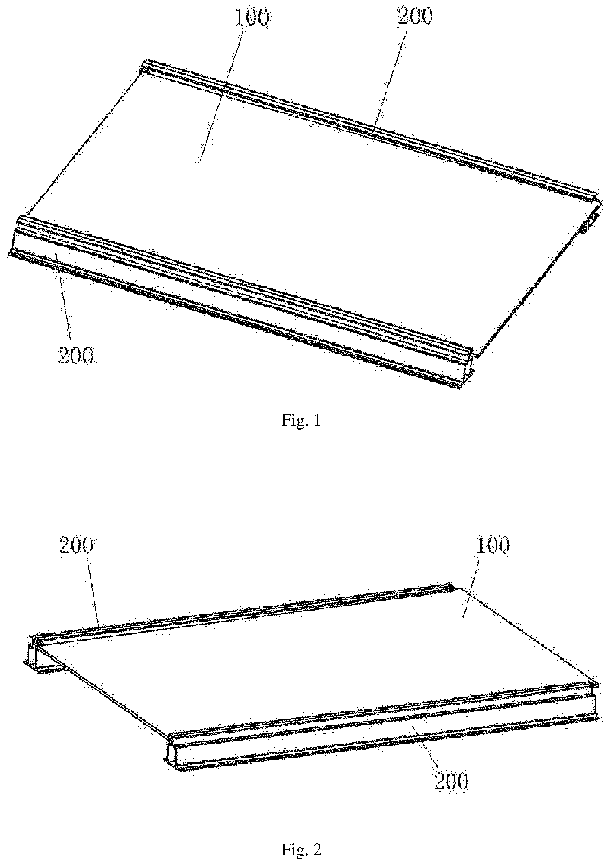

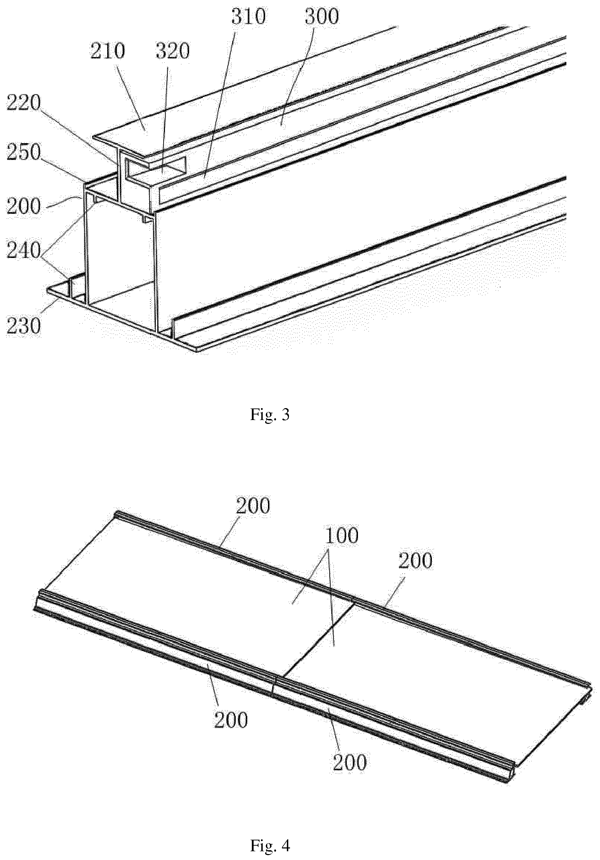

Referring to Fig. 1 to Fig. 10, a splicing mechanism for fixing a photovoltaic module is provided according to an embodiment of the present disclosure, and includes a supporting bracket 200 and a sliding rail 300. The supporting bracket 200 is provided with a fixing groove 260. The sliding rail 300 is detachably mounted in the fixing groove 260. The sliding rail 300 is provided with a first sliding groove 310 that extends a first preset distance from a first end Z1 of sliding rail 300 to a second end Z2 of the sliding rail 300, and a second sliding groove 320 that extends a second preset distance from the second end Z2 of the sliding rail 300 to the first end Z1 of sliding rail 300. The first sliding groove 310 is disposed obliquely. A projection of a center at a first end X1 of the first sliding groove 310 to a plane where a first end X2 of the second sliding groove 320 is located, coincides with a center at the first end X2 of the second sliding groove 320. A projection of a second end Y1 of the first sliding groove 310 to the plane where the first end X2 of the second sliding groove 320 is located, is below the first end X2 of the second sliding groove 320. The first end X1 of the first sliding groove 310 coincides with the first end Z1 of the sliding rail 300. The first end X1 of the second sliding groove 320 coincides with the second end Z2 of the sliding rail 300.

As shown in Figs. 1-10, the first sliding groove 310 provided on the sliding rail 300 is disposed obliquely relative to the bottom surface of the sliding rail 300. The second sliding groove 320 is disposed parallel to the bottom surface of the sliding rail 300. The first end X1 of the first sliding groove 310 and a first end X2 of the second sliding groove 320 are at the same location on opposite sides of the sliding rail 300. The first sliding groove 310 extends towards below the second sliding groove 320. In another embodiment, instead of being disposed parallel to the bottom surface of the sliding rail 300, the second sliding groove 310 may be disposed parallel to the first sliding groove 310. This however increases the thickness of the sliding rail 300.

A photovoltaic module 100 is usually a plate-like structure of uniform thickness. When fixing a single photovoltaic module 100, two splicing mechanisms may be symmetrically disposed so that edges at two sides of the plate-like photovoltaic module 100 snap into the first sliding grooves 310 of the two opposite sliding grooves 300, thereby achieving a fixed installation. In the related art, after the plate-like photovoltaic module 100 is fixed, water on the photovoltaic module 100 cannot be removed in time and the water is gradually disappeared by natural evaporation, resulting that it is difficult to maintain a surface state of the photovoltaic module 100. In this embodiment, the first sliding groove 310 in the sliding rail 300 is disposed obliquely, and then the photovoltaic module 100 mounted in the first sliding groove 310 is in an inclined state, thereby enabling liquid on the photovoltaic module 100 to flow downwardly in time and then solving problems of water accumulation on the photovoltaic module 100 in the related art.

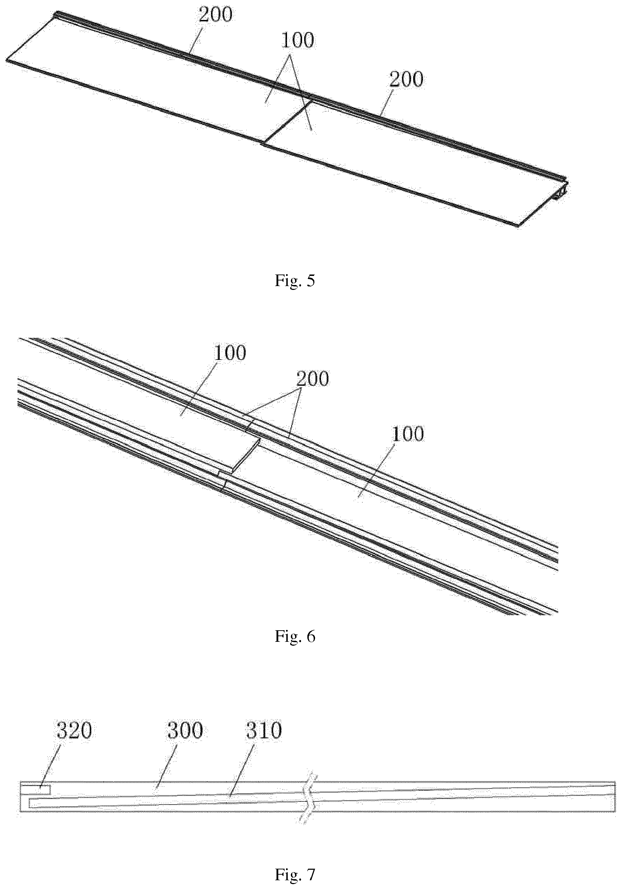

Specifically, referring to Fig. 7 to Fig. 9, the first end X1 of the first sliding groove 310 extends through the first end Z1 of the sliding rail 300 and the second end Y1 of the first sliding groove 310 does not extend through the second end Z2 of the sliding rail 300, thereby providing limiting and supporting functions for installation of the photovoltaic module 100. Further, the first end X2 of the second sliding groove 320 extends through the second end Z2 of the sliding rail 300, and the second preset distance by which the second sliding groove 320 extends in a length direction of the sliding rail 300 may be less than the first preset distance by which the first sliding groove 310 extends in the length direction of the sliding rail 300. It should be noted that, the projection of the center at the first end X1 of the first sliding groove 310 to the plane where the first end X2 of the second sliding groove 320 is located, coincides with the center at the first end X2 of the second sliding groove 320, thus, the first end X2 of the second sliding groove 320 of one sliding rail 300 can be communicated with the first end X1 of the first sliding groove 310 of another sliding groove 300. When the photovoltaic module 100 is mounted in the first sliding groove 310 of one sliding rail 300, one side of the photovoltaic module 100 adjacent the first end X1 of the first sliding groove 310 has a protrusion protruding out from an end surface of the first end X1 of the first sliding groove 310. The protrusion may be inserted into the second sliding groove 320 of another sliding rail 300, thereby achieving fixation of two ends of the photovoltaic module 100 and improving reliability of installation and fixation of the photovoltaic module 100. Meanwhile, several splicing mechanisms can be spiced in the length direction of the sliding rail 300 by the protrusions, thereby achieving fixation and installation of several photovoltaic modules 100 to form a photovoltaic curtain wall, and avoiding the problems of water accumulation on the assembled photovoltaic modules 100.

In the above embodiment, the sum of the first preset distance and the second preset distance may be set equal to or slightly greater than the length of the photovoltaic module 100. This can better improve reliability of installation and fixation of the photovoltaic module 100, enabling several splicing mechanisms for fixing photovoltaic modules 100 to be spiced in the length direction of the sliding rail 300 to form a photovoltaic curtain wall.

The above photovoltaic module 100 may include only chips, or may further include a frame for supporting and protecting the chips.

It should be noted that, in order to facilitating installation of the photovoltaic module 100, an angle β defined between the first sliding groove 310 that is obliquely disposed and a bottom surface of the sliding rail 300 may be 0.47 ± 0.03 degrees.

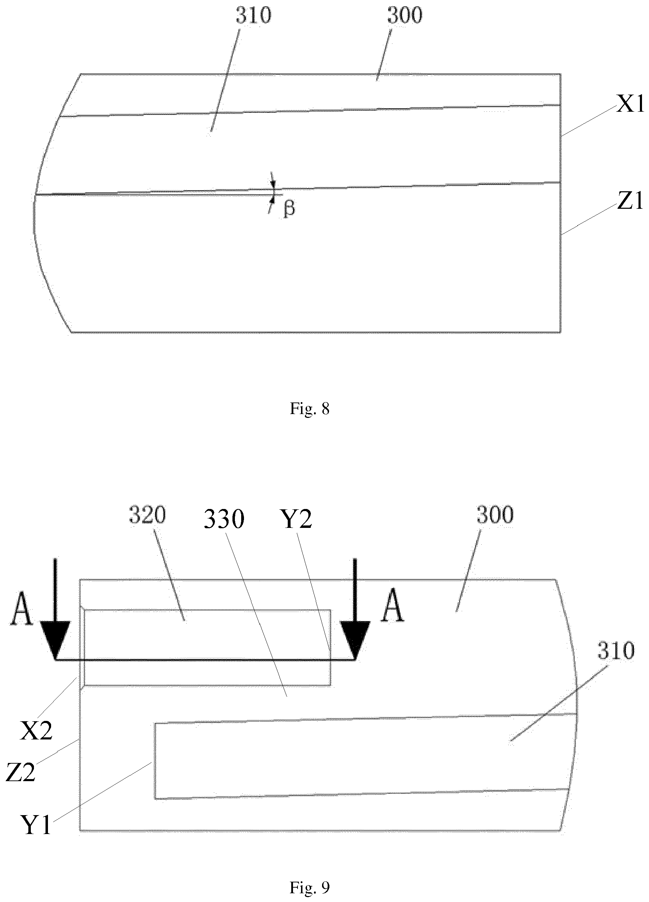

In order to prevent end portions of the photovoltaic module 100 from being deformed under the influence of temperature, as shown in Fig. 9, a partition plate 330 may be disposed between the second sliding groove 320 and the first sliding groove 310 in a direction perpendicular to the bottom surface of the sliding rail 300. When the sliding rail 300 is provided with the first sliding groove 310 and the second sliding groove 320, the partition plate 330 is formed due to the first sliding groove 310 extending towards below the second sliding groove 320, thereby providing supporting for the end portions of the photovoltaic module 100 to prevent deformation of the end portions of the photovoltaic module 100.

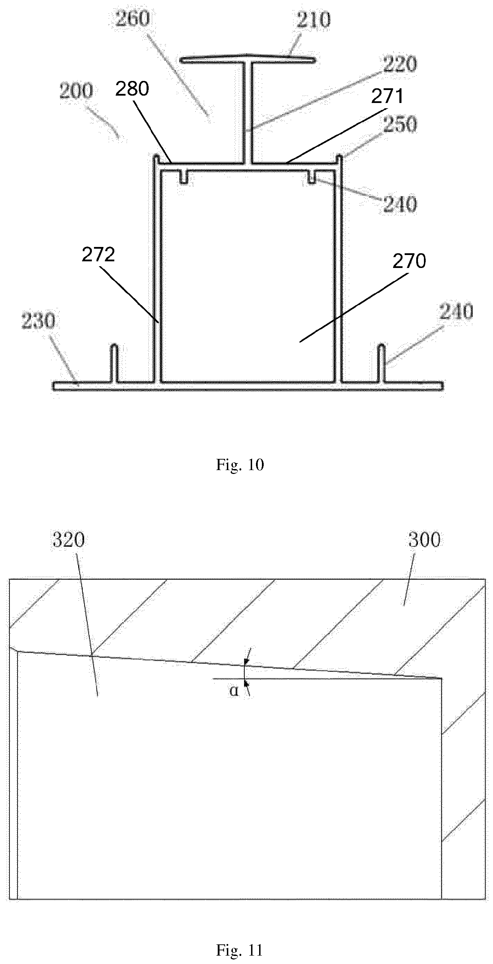

Further, as shown in Fig. 11, a preset angle α, which may be 0.5±0.05 degrees, is defined between one surface of the second sliding groove 320 extending along the length direction of the sliding rail 300 and a lateral surface of the sliding rail 300. In other words, the second sliding groove 320 is of a bell shape with a size gradually reducing in a direction from the first end X1 of the second sliding groove 320 to the second end Y2 of the second sliding groove 320. When the photovoltaic module 100 engages in the second sliding groove 320, there may be a certain gap between the photovoltaic module 100 and the second sliding groove 320, thereby preventing occurrence of difficult installation or overpressure of the photovoltaic module 100 due to thermal expansion and cold contraction of materials. Additionally, the first end X2 of the second sliding groove 320 has a taper-shaped opening, thereby facilitating insertion of the photovoltaic module 100.

In order to timely discharge the liquid on the splicing mechanism for fixing the photovoltaic module, the supporting bracket 200 may be provided with a waterproof groove 280, so that the liquid may flow out of the supporting bracket 200 through the waterproof groove 280.

Specifically, as shown in Fig. 10, the supporting bracket 200 may include a supporting portion 270, a vertical plate 220, and a cover plate 210. One end of the vertical plate 220 is fixedly connected to a top surface of the supporting portion 270, and the other end of the vertical plate 220 is fixedly connected to the cover plate 210. The fixing groove 260 is defined between the cover plate, the vertical plate 220 and the top surface of the supporting portion 270. The cover plate 210 and the vertical plate 220 can provide limiting functions in the horizontal direction and the vertical direction for the sliding rail 300, thereby ensuring reliability of installation and fixation of the sliding rail 300. Further, the vertical plate is disposed at a symmetric center of the supporting portion, thus, the vertical plate may divide a top portion above the supporting portion into two symmetrical fixing grooves 260, so that two sides of the supporting bracket 200 can fix photovoltaic modules 100. In this way, several splicing mechanisms may be arranged parallel to each other with one photovoltaic module 100 fixed between every two adjacent splicing mechanisms, thereby forming the photovoltaic curtain wall that is composed of several photovoltaic modules that are spliced sequentially.

Further, a drainage plate 250 is disposed at each of two ends in a width direction of the supporting portion 270. The drainage plate 250 protrudes out from a top surface of the supporting portion 270. The drainage plates 250 and the top surface of the supporting portion 270 together define the waterproof groove 280, which enables liquid flowing into the supporting bracket 200 to flow out through the waterproof groove 280, thereby further improving waterproof function and then ensuring the surface state of the photovoltaic module 100.

Specifically, as shown in Fig. 10, the supporting portion 270 may include a top supporting plate 271, a bottom plate 230 and two lateral supporting plates 272. One end of each of the two lateral supporting plates 272 is fixedly connected to a respective one of two ends in a width direction of the top supporting plate 271. The other end of each of the two lateral supporting plates 272 is fixedly connected to the bottom plate 230. In this way, the supporting portion is a frame-like structure with an increased structural stability.

In order to increase the structural strength of the supporting bracket 200, a rib 240 may be provided on each of the top supporting plate 271 and the bottom plate 230.

One embodiment of the present disclosure further provides a photovoltaic curtain wall that includes several photovoltaic modules 100. The photovoltaic curtain wall further includes several splicing mechanisms for fixing photovoltaic modules 100 provided in any one embodiment of the present disclosure. Two opposite sides of each photovoltaic module are mounted into the first sliding grooves 310 of two splicing mechanisms, and one ends of the two opposite sides protruding from the first sliding grooves 31 are respectively inserted into the second sliding grooves 320 of other two splicing mechanisms adjacent to the two splicing mechanisms. Specifically, in one embodiment, four splicing mechanisms may be arranged parallel to each other, with one photovoltaic module 100 fixed between every two adjacent splicing mechanisms, thereby forming a photovoltaic curtain wall that is composed of three photovoltaic modules that are spliced. Of course, further to this, in a length direction of the four splicing mechanisms, another four splicing mechanisms may further be spliced to the four splicing mechanisms, thereby forming a photovoltaic curtain wall that is composed of six photovoltaic modules 100. Of course, the specific quantity of the photovoltaic modules may be designed according to actual needs, which is not limited.

According to the splicing mechanism for fixing the photovoltaic module and the photovoltaic curtain wall provided in the embodiments of the present disclosure, the presence of the sliding rail on the supporting bracket achieves installation and fixation of the photovoltaic module; meanwhile, the sliding groove that is obliquely disposed in the sliding rail can solve problems of water accumulation on the photovoltaic module and achieve waterproof effects.

It will be appreciated that the present disclosure is not limited to the exact construction that has been described above and illustrated in the accompanying drawings, and that various modifications and changes can be made without departing from the scope thereof. It is intended that the scope of the disclosure only be limited by the appended claims.

## Claims

1. A splicing mechanism for fixing a photovoltaic module, comprising:
a supporting bracket (200) with a fixing groove (260); and
a sliding rail (300) detachably mounted in the fixing groove (260);
wherein the sliding rail is provided with a first sliding groove (310) that extends a first preset distance from a first end of sliding rail towards a second end of the sliding rail, and a second sliding groove (320) that extends a second preset distance from the second end of the sliding rail towards the first end of sliding rail; the first sliding groove (310) is disposed obliquely; a projection of a center at a first end of the first sliding groove (310) to a plane, where a first end of the second sliding groove (320) is located, coincides with a center at the first end of the second sliding groove; a projection of a second end of the first sliding groove (310) to the plane, where the first end of the second sliding groove (320) is located, is below the first end of the second sliding groove; the first end of the first sliding groove (310) coincides with the first end of the sliding rail (300); and the first end of the second sliding groove (320) coincides with the second end of the sliding rail (300).

2. The splicing mechanism of claim 1, wherein the first preset distance is greater than the second preset distance.

3. The splicing mechanism of claim 2, wherein a partition plate (330) is disposed between the second sliding groove (320) and the first sliding groove (310) in a direction perpendicular to a bottom surface of the sliding rail (300).

4. The splicing mechanism of claim 2, wherein the second sliding groove (320) is of a bell shape with a size gradually reducing in a direction from the first end of the second sliding groove towards the second end of the second sliding groove.

5. The splicing mechanism of claim 1, wherein the supporting bracket (200) is provided with a waterproof groove (280).

6. The splicing mechanism of any of claims 1-5, wherein the supporting bracket (200) includes a supporting portion (270), a vertical plate (220), and a cover plate (210); one end of the vertical plate (220) is fixedly connected to a top surface of the supporting portion (270), and the other end of the vertical plate (220) is fixedly connected to the cover plate (210); the fixing groove (260) is defined between the cover plate (210), the vertical plate (220) and the top surface of the supporting portion (270); and
wherein the vertical plate (220) is disposed at a symmetric center of the supporting portion (270), and the vertical plate (220) divides a top portion above the supporting portion (270) into two symmetrical fixing grooves (260).

7. The splicing mechanism of claim 6, wherein a drainage plate (250) is disposed at each of two ends in a width direction of the supporting portion (270); the drainage plate (250) protrudes out from the top surface of the supporting portion (270); and the drainage plates (250) and the top surface of the supporting portion (270) together define the waterproof groove (280).

8. The splicing mechanism of claim 6, wherein the supporting portion (270) includes a top supporting plate (271), a bottom plate (230) and two lateral supporting plates (272); one end of each of the two lateral supporting plates (272) is fixedly connected to a respective one of two ends in a width direction of the top supporting plate; the other end of each of the two lateral supporting plates (272) is fixedly connected to the bottom plate (230).

9. The splicing mechanism of claim 8, wherein a rib (240) is provided on each of the top supporting plate (271) and the bottom plate (230).

10. The splicing mechanism of claim 1, wherein an angle (α) defined between the first sliding groove (310) that is obliquely disposed and a bottom surface of the sliding rail (300) is in a range of 0.47±0.03 degrees.

11. A splicing mechanism for fixing a photovoltaic module, comprising:
a sliding rail (300),
wherein the sliding rail is provided with a first sliding groove (310) that extends from a first end of sliding rail towards a second end of the sliding rail, and a second sliding groove (320) that extends from the second end of the sliding rail towards the first end of sliding rail; the first sliding groove (310) is disposed obliquely relative to a bottom surface of the sliding rail (300); and a first end of the first sliding groove (310) and a first end of the second sliding groove (320) are at the same location on opposite sides of the sliding rail (300).

12. The splicing mechanism of claim 11, wherein the first sliding groove (310) extends towards below the second sliding groove (320).

13. The splicing mechanism of claim 12, wherein the second sliding groove (320) is disposed parallel to the bottom surface of the sliding rail (300).

14. The splicing mechanism of claim 13, wherein the first end of the second sliding groove (320) has a taper-shaped opening.

15. A photovoltaic curtain wall comprising a plurality of photovoltaic modules; wherein the photovoltaic curtain wall further includes a plurality of splicing mechanisms of any one of claims 1 to 14; and
wherein two opposite sides of each photovoltaic module (100) are mounted into the first sliding grooves (310) of two of the plurality of splicing mechanisms, and one ends of the two opposite sides protruding from the first sliding grooves (310) are respectively inserted into the second sliding grooves (320) of other two of the plurality of splicing mechanism adjacent to the two of the plurality of splicing mechanisms.
